(19) Europäisches Patentamt
European Patent Office
Office européen des brevets

(11) **EP 4 648 079 A1**

(12) **EUROPEAN PATENT APPLICATION**

(43) Date of publication:
**12.11.2025 Bulletin 2025/46**

(51) International Patent Classification (IPC):
**H01H 47/00** *(2006.01)*

(21) Application number: **24175067.8**

(52) Cooperative Patent Classification (CPC):
**H01H 47/002;** H01H 47/04; H01H 50/045;
H01H 50/20

(22) Date of filing: **09.05.2024**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ABB Schweiz AG**
**5400 Baden (CH)**

(72) Inventors:
• **Villano, Massimiliano**
**24044 Dalmine (BG) (IT)**
• **Taborelli, Carlo**
**21040 Venegono Inferiore (VA) (IT)**

(74) Representative: **De Bortoli, Eros et al**
**Zanoli & Giavarini S.p.A.**
**Via Melchiorre Gioia, 64**
**20125 Milano (IT)**

(54) **SWITCHING APPARATUS FOR ELECTRICAL SYSTEMS AND DIAGNOSTIC METHOD THEREOF**

(57)    A switching apparatus for electrical applications comprising:
- one or more switch poles;
- for each switch pole, one or more fixed contacts and one or more movable contacts. The movable contacts are reversibly movable between an uncoupled position, at which said movable contacts are decoupled from said fixed contacts, and a coupled position, at which said movable contacts are coupled with said fixed contacts;

- an actuation assembly operatively coupled to said movable contacts and including an electromagnetic actuator.

The switching apparatus includes or is operatively coupled to a control unit for controlling the functionalities of the switching apparatus.

Such a control unit is adapted to carry out a diagnostic method to monitor the operation of the switching apparatus during a switching manoeuvre.

FIG. 1

EP 4 648 079 A1

## Description

The present invention concerns a switching apparatus for electrical systems, such as a circuit breaker, a contactor, a disconnector, or the like. More specifically, the present invention relates to a switching apparatus of the electromagnetic type, which is particularly adapted for installation in medium voltage electrical systems.

Switching apparatuses of the electromagnetic type are widely used in electrical systems, particularly in electric grids or switchgears operating at medium voltage levels.

In general, these devices represent an important improvement with respect to most traditional mechanical switching apparatuses. However, wear phenomena of the electric contacts, changes in operational conditions of the motion transmission components, deterioration phenomena in the electromagnetic actuator, and the like may have a strong influence on their performances. Monitoring the performances of these devices, particularly during their switching manoeuvres, is therefore quite important to prevent faults and timely plan maintenance interventions.

A traditional approach to collect diagnostic information about the operation of a switching apparatus of the electromagnetic type consists in arranging a number of sensors to monitor the behaviour of the most critical components of the switch poles. However, these sensing arrangements often entail an increase of the overall size of the switch poles and higher manufacturing costs. They can thus be difficult and expensive to implement at industrial level.

EP3460822A1 discloses a more recent diagnostic method to check the operating conditions of a switching apparatus of electromagnetic type. Such a diagnostic method provides for using a mathematical model of the electromagnetic actuator to reconstruct the travel waveforms of the movable contacts of the switch poles based on the observation of the waveforms of the voltage and current applied to the electromagnetic actuator.

This solution provides relevant advantages as it allows avoiding the installation of dedicated sensors to monitor the behaviour of the switching apparatus. Additionally, it allows collecting accurate diagnostic information about anomalies during the switching manoeuvres. This diagnostic approach, however, requires performant computational resources for being implemented in practice. Therefore, it may be difficult to execute at local level, for example by a control unit mounted on-board the switching apparatus.

In the state of the art, it is quite felt the need for innovative solutions that allow overcoming or mitigating the above-evidenced limitations and drawbacks of the currently available solutions.

The present invention intends to fulfil this need by providing a switching apparatus for electrical applications, according to the following claim 1 and the related dependent claims.

In a general definition, the switching apparatus of the invention comprises:

- one or more switch poles;
- for each switch pole, one or more fixed contacts and one or more movable contacts. The movable contacts are reversibly movable between an uncoupled position, at which said movable contacts are decoupled from said fixed contacts, and a coupled position, at which said movable contacts are coupled with said fixed contacts;
- an actuation assembly operatively coupled to said movable contacts and including an electromagnetic actuator.

The switching apparatus includes or is operatively coupled to a control unit for controlling the functionalities of the switching apparatus.

Such a control unit is adapted to carry out a diagnostic method to monitor the operation of the switching apparatus during a switching manoeuvre.

Said diagnostic method comprises the following steps:

- acquiring detection signals indicative of one or more electrical quantities related to the operation of said switching apparatus, during a switching manoeuvre of said switching apparatus;
- based on said detection signals, calculating, for each electrical quantity, a diagnostic waveform indicative of an actual behaviour of said electrical quantity, during a switching manoeuvre of said switching apparatus;
- selecting a timing parameter to be calculated in relation to a switching manoeuvre of said switching apparatus;
- selecting a diagnostic waveform and an observation time window to calculate the selected timing parameter;
- determining a perturbation instant in the selected diagnostic waveform during the selected observation time window;
- calculating the selected timing parameter based on the determined perturbation instant.

Preferably, the above-mentioned one or more electrical quantities include at least one between:

- a voltage feeding said electromagnetic actuator; and
- an excitation current feeding said electromagnetic actuator.

According to certain embodiment of the invention, the above-mentioned step of determining said perturbation instant comprises:

- calculating a first checking value indicative of the derivative over time of the selected diagnostic waveform during the selected observation time window;
- comparing said first checking value within a predefined first threshold value;
- determining said perturbation instant as an instant, at which said first checking value exceeds said first threshold value during the selected observation time window.

According to other embodiment of the invention, the above-mentioned step of determining said perturbation instant comprises:

- calculating a second checking value indicative of a difference between the selected diagnostic waveform and a reference waveform indicative of an ideal profile of said electrical quantity, during the selected observation time window;
- comparing said second checking value with a predefined second threshold value;
- determining said perturbation instant as an instant, at which said second checking value exceeds said second threshold value, during the selected observation time window.

In a further aspect, the present invention provides a diagnostic method for monitoring the operation of a switching apparatus, according to the following claim 9 and the related dependent claims.

Further characteristics and advantages of the present invention will become more apparent from the detailed description of preferred embodiments illustrated only by way of non-limitative example in the accompanying drawings, in which:

    Figures 1-2 schematically show the switching apparatus of the invention;
    Figures 3, 3A, 3B, 4, 4A, 4B, 5 schematically show an actuation assembly in the switching apparatus of the invention, according to possible variant embodiments;
    Figure 6 schematically shows a diagnostic method for checking the operating conditions of the switching apparatus, according to the invention;
    Figures 7-10 schematically show different examples of implementation of the diagnostic method according to the invention.

Referring to the cited figures, the present invention is related to a switching apparatus 1 for electrical systems, such as electric grids or switchgears.

Preferably, the switching apparatus 1 is a circuit breaker. In principle, however, it may be a switching apparatus of different type, such as a contactor, a disconnector, or the like.

The switching apparatus 1 is particularly adapted for installation in medium voltage electrical systems. In principle, however, it may be employed in electrical systems of different type, such as in low voltage electrical systems.

For the purposes of the present application, the term "low voltage" (LV) relates to operating voltages lower than 2 kV AC and 2.5 kV DC while the term "medium voltage" (MV) relates to higher operating voltages up to tens of kV, e.g., up to 72 kV AC and 100 kV DC.

The switching apparatus 1 comprises one or more switch poles, each of which includes one or more movable contacts 11 and one or more fixed contacts 10.

When the switching apparatus is installed on the field, the electric contacts 10, 11 of each switch pole are electrically connected to corresponding conductors (e.g., a phase conductors or neutral conductors) of an electrical system (not shown).

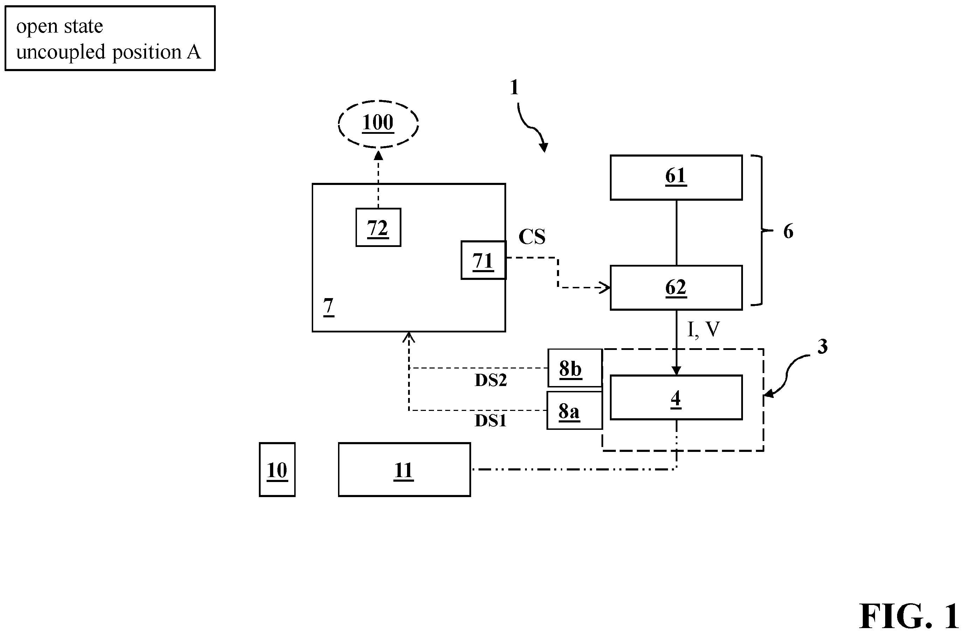

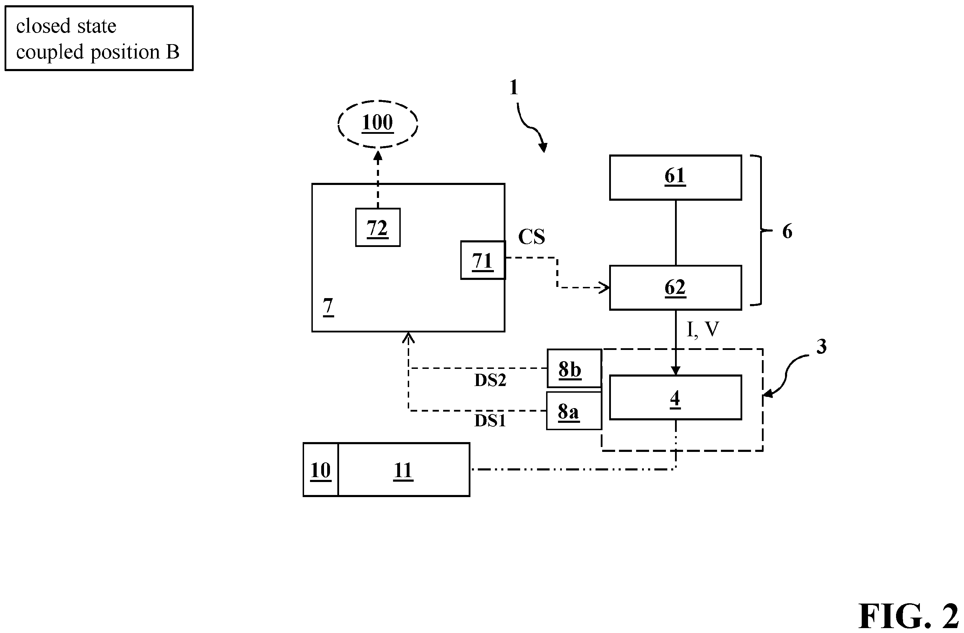

Figures 1, 2 schematically show the switching apparatus 1 according to the invention.

The movable contacts 11 are reversibly movable between an uncoupled position A, at which they are decoupled from the corresponding fixed contacts 10, and a coupled position B, at which they are coupled to said fixed contacts.

When the movable contacts 11 are in the uncoupled position A, the switching apparatus is in an open state (figure 1). In this situation, electric currents cannot flow through the switch poles.

When the movable contacts 11 are in the coupled position B, the switching apparatus is in a closed state (figure 2). In this situation, electric currents can flow through the switch poles.

The switching apparatus 1 is configured to carry out switching manoeuvres to electrically connect or disconnect different circuit sections of an electrical system, e.g., for protection purposes or maneuvering purposes.

A switching manoeuvre can be a closing manoeuvre, during which the movable contacts of the switch poles are moved from the uncoupled position A to the coupled position B, or an opening manoeuvre, during which the movable contacts of the switch poles are moved from the coupled position B to the uncoupled position A.

The switching apparatus 1 comprises an actuation assembly 3 to move the movable contacts 11 of the switch poles between the previously mentioned coupled and uncoupled positions A, B in a reversible manner.

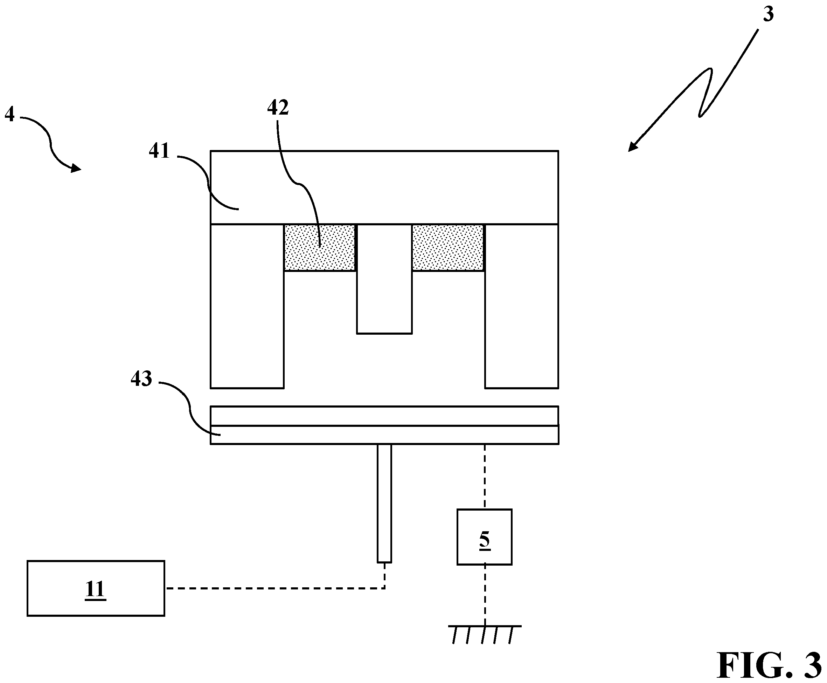

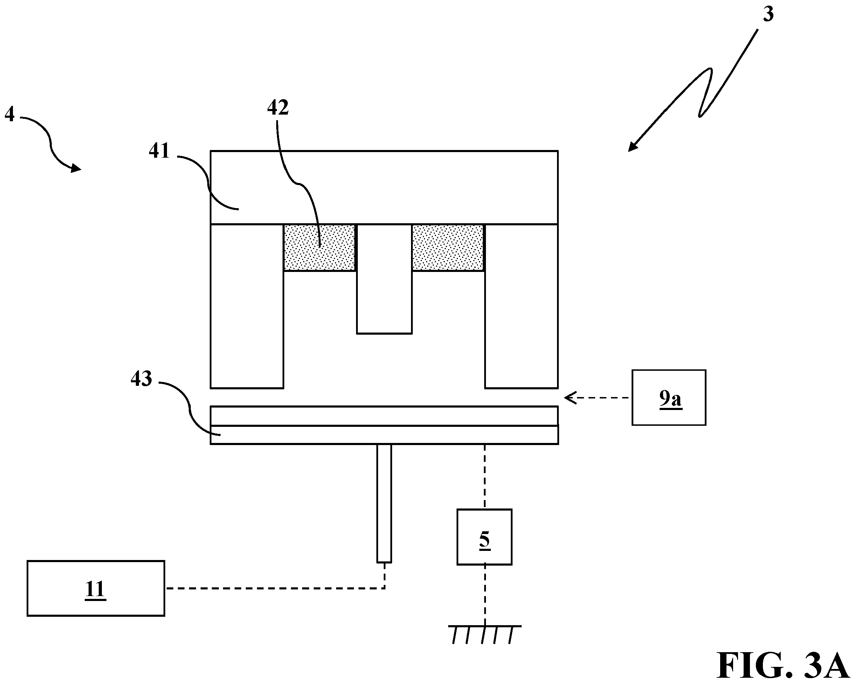

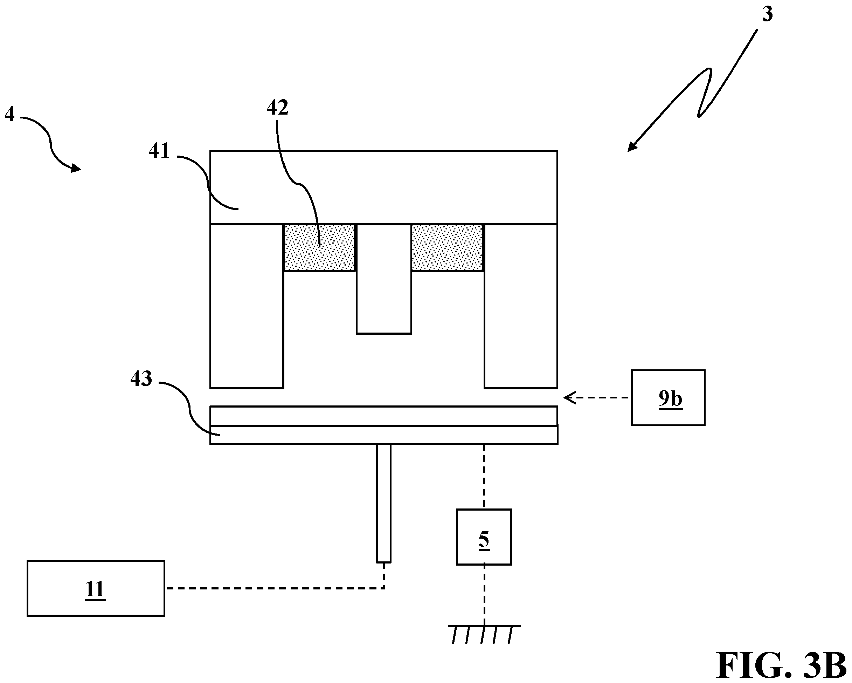

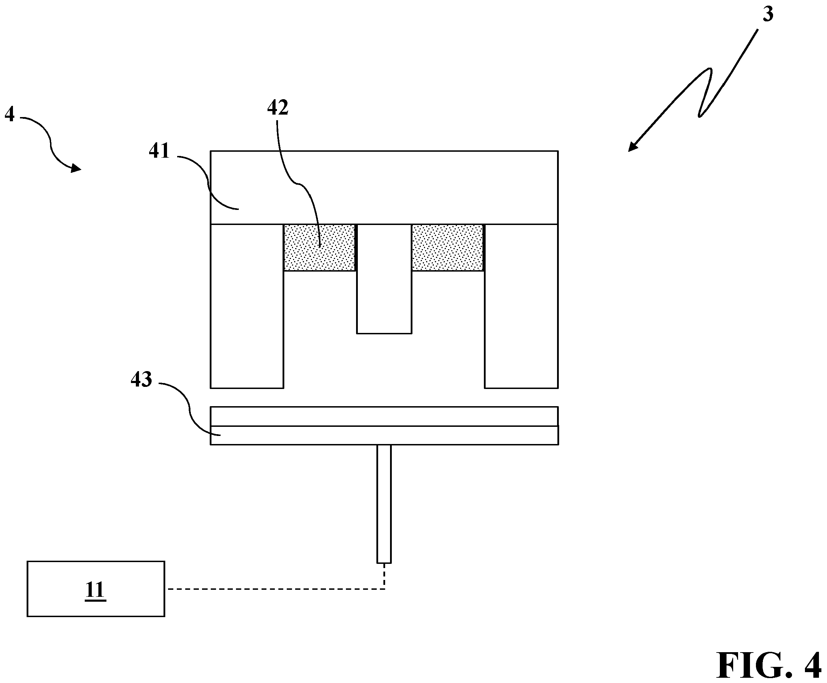

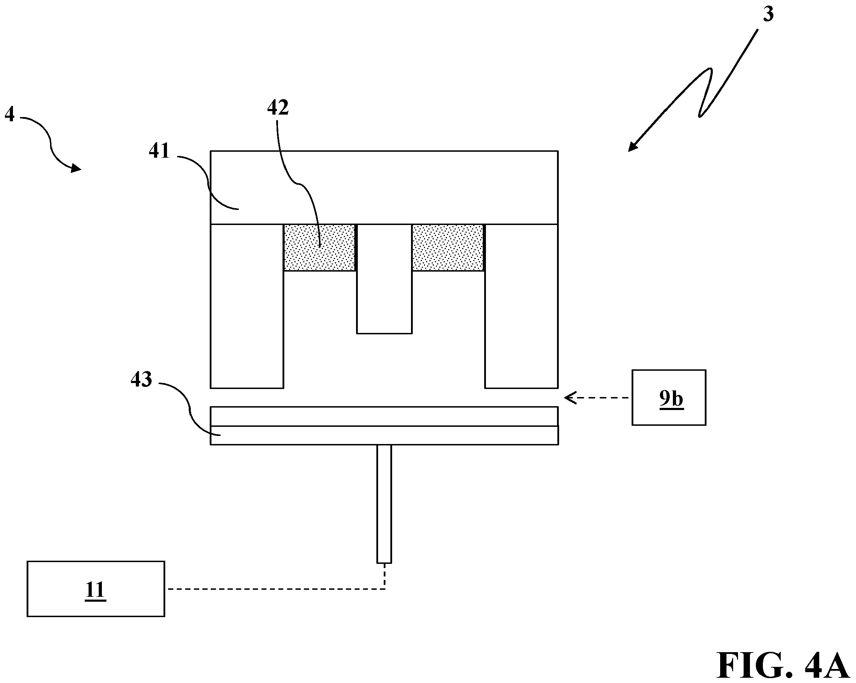

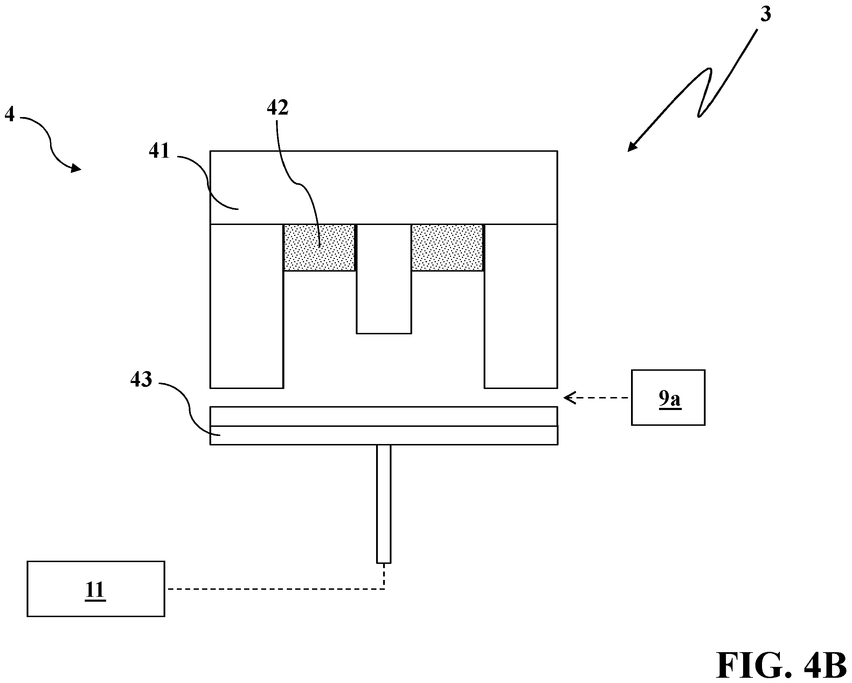

According to the invention, the actuation assembly 3 includes an electromagnetic actuator 4. Referring to figures 3, 3A, 3B, 4, 4A and 4B, the electromagnetic actuator 4 preferably includes a magnetic yoke having a fixed yoke member 41 and a movable yoke member 43 mechanically coupled to the movable contacts 11 through a suitable kinematic chain (not shown).

The movable yoke member 43 is reversibly movable between a first position, at which it is coupled to the fixed yoke member 41, and a second position, at which it is decoupled from the fixed yoke member 41.

The first position of the movable yoke member 43 corresponds to the uncoupled position A of the movable contacts 11 (figure 1) while the second position of the movable yoke member 43 corresponds to the coupled position B of the movable contacts 11 (figure 2).

The electromagnetic actuator 4 further includes an excitation arrangement 42 comprising one or more excitation windings wound around the fixed yoke member 41.

The excitation arrangement 42 can be fed with an excitation current I. This latter, when circulating in the excitation arrangement, generates a magnetic flux flowing along a magnetic circuit formed by the fixed yoke member 41 and the movable yoke member 43. The movable yoke member 43 can thus be actuated by a magnetic force due to the magnetic interaction with the fixed yoke member 41. According to some embodiments of the invention (figures 3, 3A, 3B), the actuation assembly 3 includes (in addition to the electromagnetic actuator 4) one or more opening springs 5 operatively coupled to the movable contacts 11.

In these embodiments of the invention, the electromagnetic actuator 4 provides actuation forces (of the magnetic type) directed in such a way to move the movable contacts 11 from the uncoupled position A to the coupled position B, during a closing manoeuvre of the switching apparatus. The opening springs 5 instead provide actuation forces (of the mechanical type) directed in such a way to move the movable contacts 11 from the coupled position B to the uncoupled position A, during an opening manoeuvre of the switching apparatus.

Preferably, the opening springs 5 are mechanically coupled to the movable yoke member 43 of the electromagnetic actuator. They are arranged in such a way to store elastic energy during a closing manoeuvre of the switching apparatus and release the stored elastic energy during an opening manoeuvre of the switching apparatus.

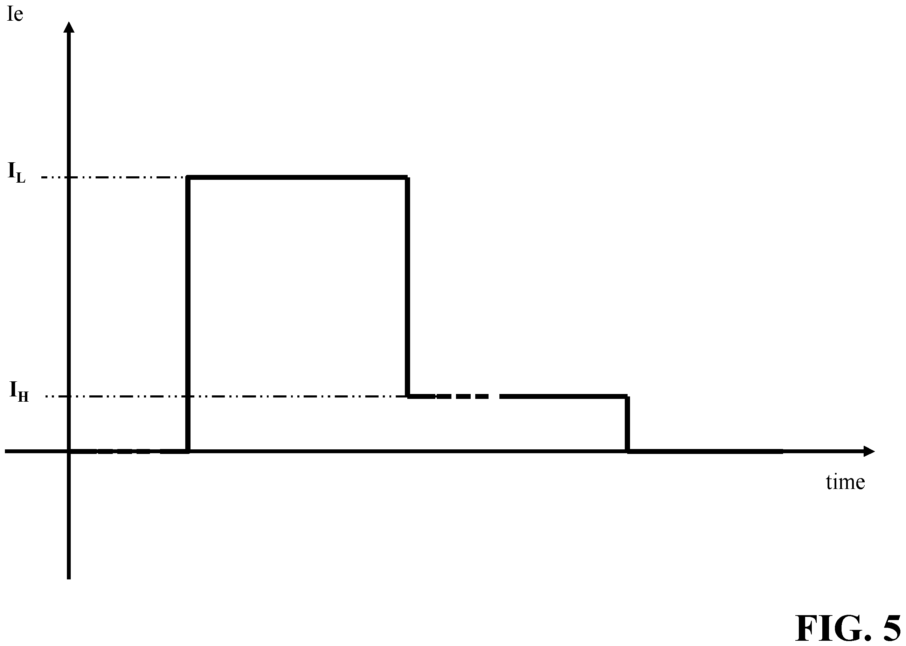

According to some variants (figures 3 and 5), the electromagnetic actuator 4 provides actuation forces (of the magnetic type) directed in such a way to maintain the movable contacts 11 in the coupled position B, when the switching apparatus is in a closed state.

In this case, the excitation arrangement 42 (which can include a single excitation winding) is fed with a first excitation current $I_L$ (launch current) during a closing manoeuvre of the switching apparatus and is fed with a lower second excitation current $I_H$ (hold current), when the switching apparatus is in a closed state.

Due to the magnetic interaction with the fixed yoke member 41, the movable yoke member 43 is maintained in the above-mentioned first position, at which it is coupled to the fixed yoke member, until the excitation arrangement 42 is fed with the hold current $I_H$. In fact, the hold current $I_H$, which circulates along the excitation arrangement 42, generates a magnetic flux directed in such a way to provide magnetic forces moving the movable yoke member 43 towards the above-mentioned first position.

To carry out an opening manoeuvre, the excitation current $I_H$ feeding the excitation arrangement 42 is interrupted and the movable yoke member 43 stops interacting magnetically with the fixed yoke member 41. The movable yoke member 43 is free to move away from the fixed yoke member 41 upon the actuation forces provided by the opening springs 5, which can release the stored elastic energy.

According to other variants (figure 3A), the actuation assembly comprises a latching mechanism 9a adapted to engage a movable component included in the electromagnetic actuator 4 or operatively coupled to said electromagnetic actuator to maintain the movable contacts 11 in the coupled position B, when the switching apparatus is in a closed state.

Preferably, the latching mechanism 9a is adapted to interact mechanically with the movable yoke member 43 of the electromagnetic actuator. To this aim, the latching mechanism 9a can be actuated by a dedicated actuator, such as an actuation coil.

As soon as the switching apparatus has completed a closing manoeuvre, the latching mechanism 9a engages the movable yoke member 43 and blocks it in the above-mentioned first position, at which it is coupled to the fixed yoke member 41.

To carry out an opening manoeuvre, the latching mechanism 9a is released. The movable yoke member 43 is free to move away from the fixed yoke member 41 upon the actuation forces provided by the opening springs 5, which can release the stored elastic energy.

As an alternative, the latching mechanism 9a can interact mechanically with a motion transmission member (not shown) mechanically coupling the movable yoke member 43 of the electromagnetic actuator and the movable contacts 11.

According to further variants (figure 3B), the actuation assembly comprises one or more permanent magnets 9b operatively coupled to the electromagnetic actuator 4 and adapted to provide actuation forces (of the magnetic type) directed in such a way to maintain the movable contacts 11 in the coupled position B, when the switching apparatus is in a closed state.

The permanent magnets 9b are adapted to generate a magnetic flux flowing along a magnetic circuit formed by the fixed yoke member 41 and the movable yoke member 43 and directed in such a way to provide actuation forces moving the movable yoke member towards the above-mentioned first position, at which it is coupled with the fixed yoke member 41.

When the closing manoeuvre is completed, the movable contacts 11 are thus maintained in the coupled position even if the excitation arrangement 42 of the electromagnetic actuator is no more fed. To carry out an opening manoeuvre, the excitation arrangement 42 (which can include a single excitation winding) is fed with a small excitation current generating a magnetic flux having an opposite direction and a higher intensity compared to the magnetic flux generated by the permanent magnets 9b. The magnetic force generated by the permanent magnets 9b is thus compensated and the movable yoke member 43 is free to move away from the fixed yoke member 41 upon the actuation forces provided by the opening springs 5, which can release the stored elastic energy.

According to some embodiments of the invention (figures 4, 4A, 4B), the electromagnetic actuator 4 provides actuation forces (of the magnetic type) directed in such a way to move the movable contacts 11 from the uncoupled position A to the coupled position B, during a closing manoeuvre of the switching apparatus, and provides actuation forces of the magnetic type directed in such a way to move the movable contacts 11 from the coupled position B to the uncoupled position A, during an opening manoeuvre of the switching apparatus.

In this case, the excitation arrangement 42 can advantageously include a closing excitation winding and an opening excitation winding fed with opposite excitation currents during a closing manoeuvre and an opening manoeuvre of the switching apparatus.

According to some variants (figures 4 and 5), the electromagnetic actuator 4 provides actuation forces (of the magnetic type) directed in such a way to maintain the movable contacts 11 in the coupled position B, when the switching apparatus is in a closed state.

The excitation arrangement 42 is fed with a first launch current during a closing manoeuvre of the switching apparatus and is fed with a lower hold current, when the switching apparatus is in a closed state.

The excitation arrangement 42 is fed with a second launch current, which has an opposite direction compared to the above-mentioned first launch current, during an opening manoeuvre of the switching apparatus and is fed with a lower second hold current, which has an opposite direction compared to the above-mentioned first hold current, when the switching apparatus is in a closed state.

According to other variants (figure 4A), the actuation assembly 3 preferably comprises one or more permanent magnets 9b operatively coupled to the electromagnetic actuator 4 and adapted to provide actuation forces (of the magnetic type) directed in such a way to maintain the movable contacts 11 in the coupled position B, when the switching apparatus is in a closed state and in an open state (as explained above).

The actuation assembly 3 preferably comprises also one or more permanent magnets 9b operatively coupled to the electromagnetic actuator 4 and adapted to provide actuation forces (of the magnetic type) directed in such a way to maintain the movable contacts 11 in the uncoupled position A, when the switching apparatus is in an open state.

According to further variants (figure 4B), the actuation assembly comprises a latching mechanism 9a adapted to engage a movable component included in the electromagnetic actuator 4 or operatively coupled to said electromagnetic actuator to maintain the movable contacts 11 in the coupled position B and, possibly, in the uncoupled position A, when the switching apparatus is in a closed state and, possibly, in an open state.

Preferably, the latching mechanism 9a is adapted to interact mechanically with the movable yoke member 43 of the electromagnetic actuator. As explained above, the latching mechanism 9a can be actuated by a dedicated actuator, such as an actuation coil.

Preferably, the switching apparatus 1 further comprises a driving unit 6 electrically connected to the electromagnetic actuator 4 and adapted to feed the electromagnetic actuator with an excitation current I.

Referring again to figures 1-2, the driving unit 6 preferably comprises power supply means 61 to harvest the electric power necessary to operate the electromagnetic actuator 4.

The power supply means 61 may comprise a capacitor bank to store electric energy for operating the electromagnetic actuator 4 and a power supply circuit electrically connected to a power source (for example the electric line on which the switching apparatus is installed) and capable of continuously charging the previously mentioned capacitor bank.

Preferably, the driving unit 6 comprises a driving circuit 62 electrically connected to the electromagnetic actuator 4, namely to the excitation arrangement 42, and to the power supply means 61.

The driving circuit 62 is adapted to provide the excitation current to operate the electromagnetic actuator upon receiving suitable control signals CS from an electronic device, for example a control unit of the switching apparatus.

The driving circuit 62 may include one or more suitable switching circuits and other electronic circuits controllable by a suitable control unit.

Preferably, the switching apparatus 1 comprises first sensing means 8a adapted to provide first detection signals DS1 indicative of the excitation current I feeding the electromagnetic actuator. The first sensing means 8a can include, for example, one or more current sensors (e.g., current transformers, Hall sensors, shunt circuits, and the like) operatively coupled to the excitation arrangement 42 of the electromagnetic actuator.

Preferably, the switching apparatus 1 comprises second sensing means 8b adapted to provide second detection signals DS2 indicative of a voltage V feeding the electromagnetic actuator 4. The second sensing means 8b can include, for example, one or more voltage sensors (e.g., capacitive sensors, shunt circuits, and the like) operatively coupled to the excitation arrangement 42 of the electromagnetic actuator.

In general terms, the above-mentioned actuation assembly 3, driving unit 6 and sensing means 8a, 8b may be arranged to solutions of known type. Therefore, these components of the switching apparatus will be described hereinafter only in relation to the sole aspects of interest of the invention, for the sake of brevity.

The switching apparatus 1 comprises a control unit 7 for controlling the operation of the switching apparatus (figures 1-2).

Preferably, the control unit 7 comprises suitable digital processing devices (e.g., one or more microprocessors) adapted to execute software instructions to generate control/data signals to manage the operating life of the switching apparatus 1. In principle, however, the control unit 7 may include electronic circuits of the analogic type suitably configured to carry out the requested functionalities. The control unit 7 is operatively coupled to the driving unit 6 and is configured to control the latter by providing suitable control signals CS, for example to the driving circuit 62. Conveniently, the control unit 7 is operatively coupled also to the sensing means 8a, 8b to receive the above-mentioned detection data DS1, DS2 from the latter.

Preferably, the control unit 7 comprises a regulator block 71 configured to control the driving unit 6 based on the detection signals DS1, DS2 provided by the sensor means 8a, 8b.

The regulator block 71 may include, for example, a PID regulator.

Preferably, the above-mentioned switching circuits of the driving unit 6 and the sensor means 8a, 8b implement a control loop configured to carry out a PWM regulation of the excitation current I feeding the electromagnetic actuator. The electromagnetic actuator 4 can thus be fed as described above during the operation of the switching apparatus.

The regulator block 71 is preferably digitally implemented. In this case, a microcontroller of the control unit 7 can execute suitable software instructions for implementing the functionalities requested to the regulator block.

The control unit 7 can be a controller installed on-board the switching apparatus. As an alternatively, it may be a stand-alone device installed at local level, for example a digital relay.

An important feature of the present invention consists in that the control unit 7 is configured to execute a diagnostic method 100 to monitor the operation of said switching apparatus during a switching manoeuvre.

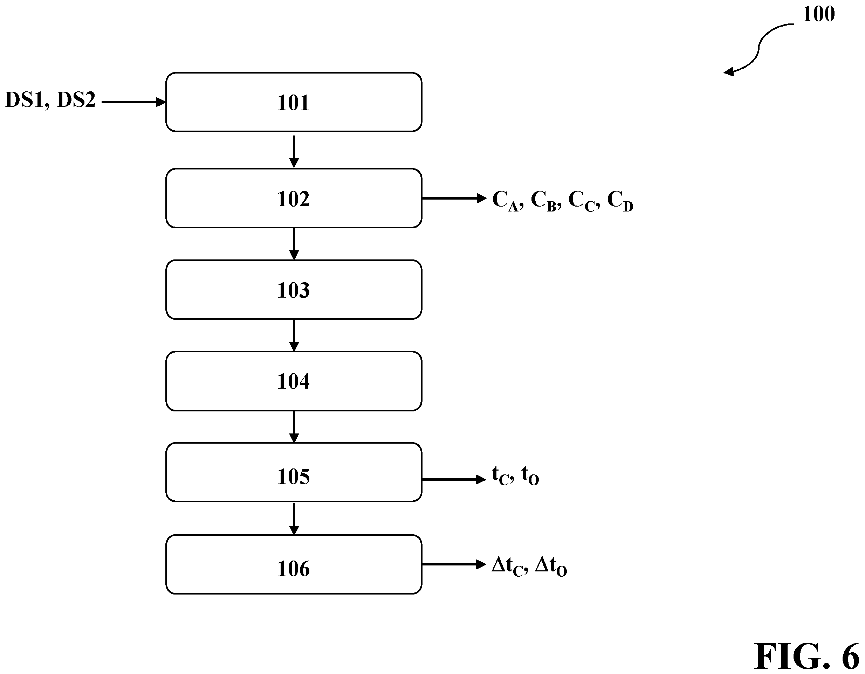

The steps of the diagnostic method 100 are now described in detail (figure 6).

The diagnostic method 100 comprises a step 101 of acquiring detection signals indicative of one or more electrical quantities of the switching apparatus, during a switching manoeuvre of this latter.

Preferably, the above-mentioned one or more electrical quantities include at least one between the following quantities:

- the voltage V feeding the electromagnetic actuator 4; and
- the excitation current I feeding the electromagnetic actuator 4.

Preferably, the diagnostic signals acquired in this step of the diagnostic method 100 are the diagnostic signals DS1, DS2 provided by the first and second sensing means 8a, 8b.

It is evidenced how these sensing means are not exclusively dedicated to the execution of the diagnostic method 100. As mentioned above, these components are basically arranged for implementing a control loop of the operation of the electromagnetic actuator. The diagnostic method 100 of the invention, however, exploits the detection information provided by these components for monitoring purposes.

The diagnostic method 100 comprises a step 102 of calculating, for each monitored electrical quantity V, I, a diagnostic waveform $C_A$, $C_B$, $C_C$, $C_D$ indicative of an actual behaviour of said electrical quantity, during a switching manoeuvre of said switching apparatus. The one or more diagnostic waveforms $C_A$, $C_B$, $C_C$, $C_D$ are conveniently reconstructed based on the acquired detection signals DS1, DS2.

The diagnostic method 100 comprises a step 103 of selecting a timing parameter to be calculated in relation to a switching manoeuvre of the switching apparatus.

As an example, a timing parameter can be the separation time $\Delta to$ of the electric contacts of the switch poles during an opening manoeuvre. Anomalies in this timing parameter may be indicative of potential problems in the actuation chain of the movable contacts 11, namely in the electromagnetic actuator 4 or in the kinematic chain coupling the movable contacts 11 with the electromagnetic actuator.

As a further example, another timing parameter can be the closing time $\Delta tc$ of the electric contacts of the switch poles during a closing manoeuvre. Anomalies in this timing parameters may be indicative of a relevant erosion condition of the electric contacts.

Additional timing parameters may be selected according to the needs, for example with the aim of reconstruct the travel waveforms of the movable contacts 11 during a switching manoeuvre of the switching apparatus.

The diagnostic method 100 comprises a step 104 of selecting a diagnostic waveform $C_A$, $C_B$, $C_C$, $C_D$ and an observation time window $T_A$, $T_B$, $T_C$, $T_D$ to check the selected timing parameter.

At this stage of the diagnostic method 100, the most suitable diagnostic waveform and observation time window to check the selected timing parameter is chosen.

For example, if the selected timing parameter is the closing time $\Delta tc$ of the electric contacts during a closing manoeuvre, a diagnostic waveform indicative of the actual behaviour of the excitation current I feeding the electromagnetic actuator 4 can be selected. A selected time window can be a time interval, during which the selected diagnostic waveform shows a stationary profile. As an alternative, a selected time window can start from an instant at which the selected diagnostic waveform exceeds a predefined value. Obviously, as it will be more apparent from the examples described below, different diagnostic waveforms and observation time windows can be selected to check a same selected time parameter.

The diagnostic method 100 comprises a step 105 of determining a perturbation instant tc, to in the selected diagnostic waveform $C_A$, $C_B$, $C_C$, $C_D$ during the selected observation time window $T_A$, $T_B$, $T_C$, $T_D$.

For the sake of clarity, it is specified that a "perturbation instant" should be intended as an instant, at which the selected diagnostic waveform shows a sudden change of its profile.

The identification of an perturbation instant tc, to in a selected diagnostic waveform $C_A$, $C_B$, $C_C$, $C_D$ (i.e., in the monitored electric quantities) allows understanding when the electrical contacts 10, 11 of the switch poles actually change their operating conditions during a switching operation of the switching apparatus, thereby passing from a coupled condition to a separated condition, or vice-versa. The inventors have, in fact, observed that the presence of a perturbation instant tc, to in a selected diagnostic waveform $C_A$, $C_B$, $C_C$, $C_D$ is strictly correlated to a change of the operating conditions of the actuation assembly 4 operatively coupled to the movable contact 11, thus being linked to the actual the travel law of the movable contact.

The diagnostic method 100 then comprises a step 106 of calculating the selected timing parameter Δtc, Δto based on the identified perturbation instant tc, to. As an example, the selected timing parameter perturbation instant Δtc, Δto can be calculated by measuring the time elapsing between an initial instant $t_0$ (which is obviously known) of the monitored switching manoeuvre and the determined perturbation instant tc, to.

According to certain embodiments of the invention, the identification step of a perturbation instant tc in a selected diagnostic waveform $C_A$, $C_B$ is based on the calculation of the derivative over time of the selected diagnostic waveform.

Preferably, the step 105 of determining the perturbation instant tc includes:

- calculating a first checking value $ck_A$, $ck_B$ indicative of the derivative over time of the selected diagnostic waveform $C_A$, $C_B$ during the selected observation time window $T_A$, $T_B$;
- comparing the calculated first checking value $ck_A$, $ck_B$ with a predefined first threshold value $TH_A$, $TH_B$;

- determining the perturbation instant tc as the instant at which the calculated first checking value $ck_A$, $ck_B$ exceeds the first threshold value $TH_A$, $TH_B$ during the selected observation time window. According to other embodiments of the invention, the identification step of a perturbation instant tc, to in a selected diagnostic waveform Cc, $C_D$ is based on the calculation of a difference value between said diagnostic waveform and a reference waveform $R_C$, $R_D$ indicative of an ideal profile for the monitored electrical quantity.

Preferably, the step 105 of determining the perturbation instant tc, to includes:

- calculating a second checking value ckc, $ck_D$ indicative of a difference between the selected diagnostic waveform $C_C$, $C_D$ and a reference waveform $R_C$, $R_D$ indicative of an ideal profile of the electrical quantity V, I during the selected observation time window $T_C$, $T_D$;
- comparing the calculated second checking value $ck_C$, $ck_D$ with a predefined second threshold value $TH_C$, $TH_D$;
- determining the perturbation instant tc, to as the instant at which the calculated second checking value $ck_C$, $ck_D$ exceeds the second threshold value $TH_C$, $TH_D$ during the selected observation time window.

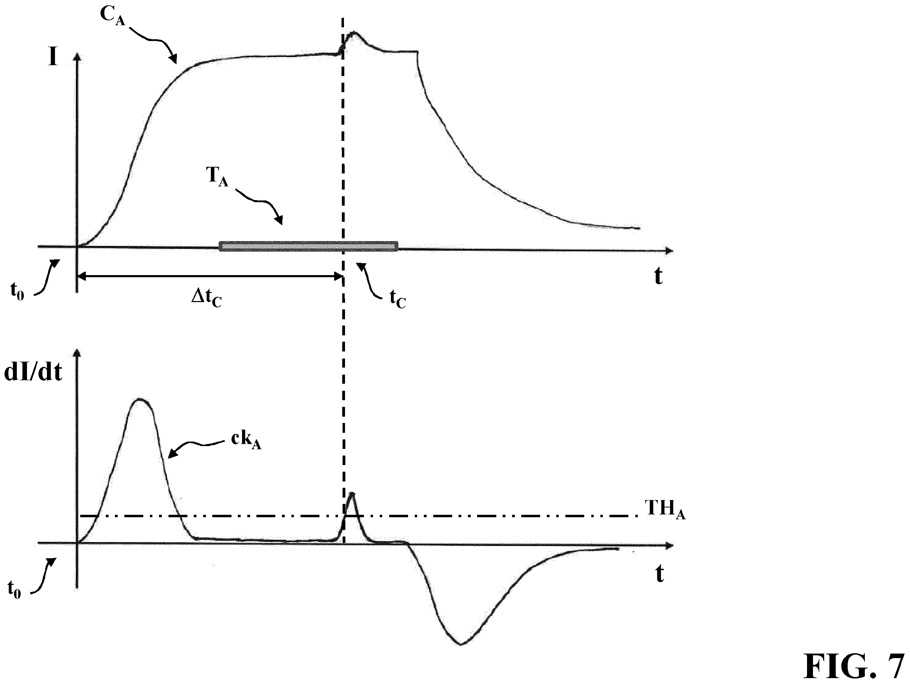

Figure 7 shows an example of practical implementation of the diagnostic method 100 according to the invention.

In this case, the selected timing parameter to be calculated is the closing time Δtc of the electric contacts 10, 11 during the closing manoeuvre of a switching apparatus equipped with an electromagnetic actuator according to the embodiment of figures 3-4.

A diagnostic waveform Ca indicative of the actual behaviour of a current I feeding the electromagnetic actuator 4 during a closing manoeuvre of the switching apparatus is selected. The selected current waveform $C_A$ has been calculated based on the acquired first detection signals DS1 provided by the first sensing means 8A.

An observation time window $T_A$ is selected, during which the selected current waveform $C_A$ shows a stationary profile.

A perturbation instant tc in the selected current waveform $C_A$ during the selected observation time window $T_A$ is determined. To this aim, it is calculated a first checking value $ck_A$ indicative of the derivative over time of the selected current waveform $C_A$ during the selected observation time window $T_A$. The calculated first checking value $ck_A$ is then compared with a predefined first threshold value THa.

The perturbation instant tc (closing instant of the electric contacts) is identified as the instant in which the first checking value $ck_A$ exceeds the predefined first threshold value $TH_A$ during the selected observation time window.

The closing time Δtc of the electric contacts 10, 11 during the closing manoeuvre is calculated based on the following relation:

$$\Delta t_C = t_C - t_0$$

where tc is the determined perturbation instant and $t_0$ is the initial instant of the closing manoeuvre.

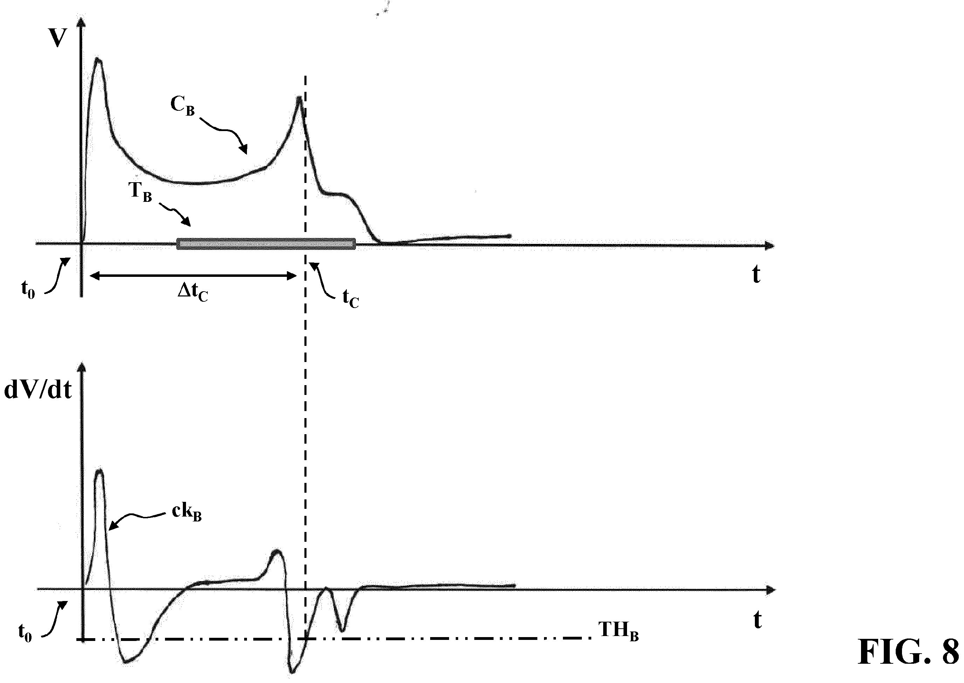

Figure 8 shows a further example of practical implementation of the diagnostic method 100 according to the invention.

Also in this case, the selected timing parameter to be calculated is the closing time $\Delta tc$ of the electric contacts 10, 11 during the closing manoeuvre of a switching apparatus equipped with an electromagnetic actuator according to the embodiment of figure 3.

A diagnostic waveform $C_B$ indicative of the actual behaviour of a voltage V feeding the electromagnetic actuator 4 of the switching apparatus is selected. The selected current waveform $C_B$ has been calculated based on the acquired second detection signals DS2 provided by the second sensing means 8B. An observation time window $T_B$ is selected, during which the selected voltage waveform $C_B$ shows a stationary profile.

A perturbation instant tc in the selected voltage waveform $C_B$ during the selected observation time window $T_B$ is determined. To this aim, it is calculated a first checking value $ck_B$ indicative of the derivative over time of the selected voltage waveform $C_B$ during the selected observation time window $T_B$. The calculated second checking value $ck_B$ is then compared with a predefined first threshold value $TH_B$.

The perturbation instant tc (closing instant of the electric contacts) is identified as the instant in which the first checking value $ck_B$ exceeds (in module) the predefined first threshold value $TH_B$ during the selected observation time window.

The closing time $\Delta tc$ of the electric contacts 10, 11 during the closing manoeuvre is calculated based on the following relation:

$$\Delta t_C = t_C - t_0$$

where tc is the determined perturbation instant and $t_0$ is the initial instant of the closing manoeuvre.

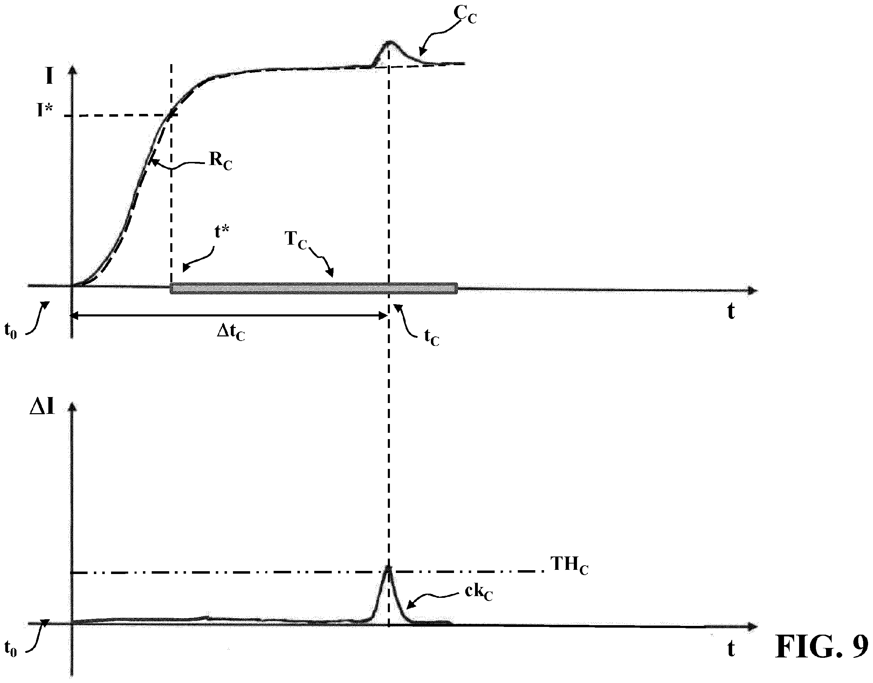

Figure 9 shows a further example of practical implementation of the diagnostic method 100 according to the invention.

In this case, the selected timing parameter to be calculated is the closing time $\Delta tc$ of the electric contacts 10, 11 during the closing manoeuvre of a switching apparatus equipped with an electromagnetic actuator according to the embodiment of figure 4.

A diagnostic waveform Cc indicative of the actual behaviour of a current I feeding the electromagnetic actuator 4 during a closing manoeuvre of the switching apparatus is selected. The selected current waveform Cc has been calculated based on the acquired first detection signals DS1 provided by the first sensing means 8A.

An observation time window $T_C$ is selected. The observation time window $T_C$ starts from an instant t* at which the selected current waveform $C_D$ exceeds a predefined value I*.

A perturbation instant tc in the selected current waveform Cc during the selected observation time window Tc is determined. To this aim, it is calculated a second checking value ckc indicative of a difference between the selected current waveform Cc and a reference waveform $R_C$ indicative of an ideal profile of the current circulating the electromagnetic actuator during a closing manoeuvre. The calculated second checking value $ck_C$ is then compared with a predefined second threshold value $TH_C$.

The perturbation instant tc (closing instant of the electric contacts) is identified as the instant in which the second checking value $ck_C$ exceeds the predefined first threshold value $TH_C$ during the selected observation time window.

The closing time $\Delta tc$ of the electric contacts 10, 11 during the closing manoeuvre is calculated based on the following relation:

$$\Delta t_C = t_C - t_0$$

where tc is the determined perturbation instant and $t_0$ is the initial instant of the closing manoeuvre.

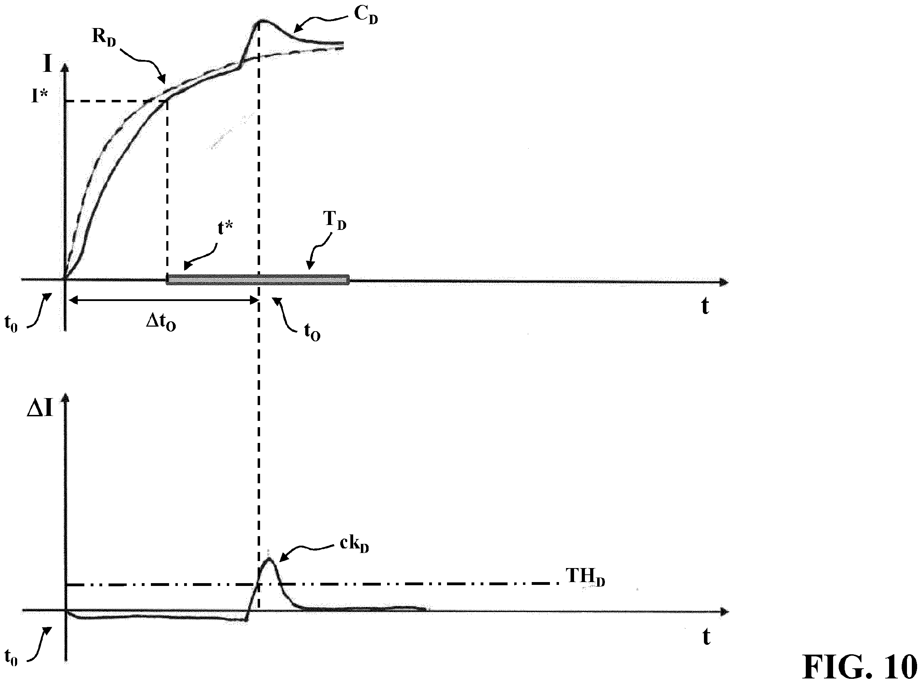

Figure 10 shows a further example of practical implementation of the diagnostic method 100 according to the invention.

In this case, the selected timing parameter to be calculated is the opening time $\Delta to$ of the electric contacts 10, 11 during the opening manoeuvre of a switching apparatus equipped with an electromagnetic actuator according to the embodiment of figure 4.

A diagnostic waveform $C_D$ indicative of the actual behaviour of a current I feeding the electromagnetic actuator 4 during an opening manoeuvre of the switching apparatus is selected. The selected current waveform $C_D$ has been calculated based on the acquired first detection signals DS1 provided by the first sensing means 8A.

An observation time window $T_D$ is selected. The observation time window $T_D$ starts from an instant t* at which the selected current waveform $C_D$ exceeds a predefined value I*.

A perturbation instant to in the selected current waveform $C_D$ during the selected observation time window $T_D$ is determined. To this aim, it is calculated a second checking value $ck_D$ indicative of a difference between the selected current waveform $C_D$ and a reference waveform $R_D$ indicative of an ideal profile of the current circulating the electromagnetic actuator during an opening manoeuvre. The calculated second checking value $ck_D$ is then compared with a predefined second threshold value $TH_D$.

The perturbation instant to (opening instant of the electric contacts) is identified as the instant in which the second checking value $ck_D$ exceeds the predefined second threshold value $TH_D$ during the selected observation time window.

The opening time $\Delta to$ of the electric contacts 10, 11 during the opening manoeuvre is calculated based on the following relation:

$$\Delta t_O = t_O - t_0$$

where tc is the determined perturbation instant and $t_0$ is the initial instant of the opening manoeuvre. Preferably, the control unit 7 comprises a monitoring block 72 configured to execute the diagnostic method 100. The monitoring block 71 is preferably digitally implemented. In this case, a microcontroller of the control unit 7 can execute suitable software instructions for carrying out the functionalities requested to the monitoring block.

As it is apparent from the above, in another aspect, the present invention relates to a diagnostic method 100 for monitoring the operating conditions of a switching apparatus 1, during a switching manoeuvre of a switching apparatus (figure 6).

The diagnostic method 100 comprises:

- a step 101 of acquiring detection signals DS1, DS2 indicative of one or more electrical quantities V, I related to the operation of the switching apparatus, during a switching manoeuvre of said switching apparatus;
- a step 102 of calculating, based on said detection signals, for each electrical quantity V, I, a diagnostic waveform $C_A$, $C_B$, $C_C$, $C_D$ indicative of an actual behaviour of said electrical quantity, during a switching manoeuvre of said switching apparatus;
- a step 103 of selecting a timing parameter Δtc, Δto to be calculated in relation to a switching manoeuvre of said switching apparatus;
- a step 104 of selecting a diagnostic waveform $C_A$, $C_B$, $C_C$, $C_D$ and an observation time window $T_A$, $T_B$, Tc, $T_D$ to calculate the selected timing parameter Δtc, Δto;
- a step 105 of determining a perturbation instant tc, to in the selected diagnostic waveform $C_A$, $C_B$, Cc, $C_D$ during the selected observation time window $T_A$, $T_B$, $T_C$, $T_D$;
- a step 106 of calculating the selected timing parameter $\Delta t_C$, Δt based on the determined perturbation instant tc, to.

According to certain embodiments of the invention, the step 105 of determining the perturbation instant tc comprises:

- calculating a first checking value $ck_A$, $ck_B$ indicative of the derivative over time of the selected diagnostic waveform $C_A$, $C_B$ during the selected observation time window $T_A$, $T_B$;
- comparing the calculated first checking value $ck_A$, $ck_B$ within a predefined first threshold value $TH_A$, $TH_B$;
- determining said perturbation instant tc as an instant, at which the calculated first checking value $ck_A$, $ck_B$ exceeds the first threshold value $TH_A$, $TH_B$ during the selected observation time window $T_A$, $T_B$.

According to other embodiments of the invention, the step 105 of determining the perturbation instant tc comprises:

- calculating a second checking value ckc, $ck_D$ indicative of a difference between the selected diagnostic waveform Cc, $C_D$ and a reference waveform RC, $R_D$ indicative of an ideal profile of the monitored electrical quantity V, I during the selected observation time window Tc, $T_D$;
- comparing the calculated second checking value ckc, $ck_D$ with a predefined second threshold value $TH_C$, $TH_D$;
- determining said perturbation instant tc, to as an instant, at which the calculated second checking value $ck_C$, $ck_D$ exceeds the second threshold value $TH_C$, $TH_D$ during the selected observation time window $T_C$, $T_D$.

The switching apparatus and the control method, according to the present invention, provides remarkable advantages with respect to the solutions of the state of the art.

In the switching apparatus of the invention, detection information, which is normally available for controlling the operation of the electromagnetic actuator, is processed through simple mathematical operations to reconstruct empirically diagnostic information (the calculated timing parameters) about the actual performances of the switching apparatus, particularly during the switching operations. Different from currently available solutions of the state of the art, for example the solution described in EP3460822A1, such diagnostic information is empirically reconstructed without the use of dedicated mathematical models describing the operation of the electromagnetic actuator. Therefore, such diagnostic information can be collected easily without the need for dedicated sensing arrangements and performant data-processing resources.

The presence of anomalies in the electric contacts, in the electromagnetic actuator and in the kinematic chain coupling the electromagnetic contacts with the electromagnetic actuator can thus be determined based on the collected diagnostic information.

This allows suitably intervening or planning maintenance operations to prevent malfunctioning or faults of the switching apparatus.

The switching apparatus of the invention is of relatively easy manufacturability at industrial levels, at competitive costs with respect to the solutions of the state of the art.

**Claims**

1. Switching apparatus (1) for electrical systems, wherein said switching apparatus comprises:

   - one or more switch poles;
   - for each switch pole, one or more fixed contacts (10) and one or more movable contacts (11), wherein said movable contacts are reversibly movable between an uncoupled position (A), at which said movable contacts are decoupled from said fixed contacts, and a coupled position (B), at which said movable contacts are coupled with said fixed contacts;
   - an actuation assembly (3) operatively coupled to said movable contacts (11), wherein said actuation assembly includes an electromagnetic actuator (4);

      wherein said switching apparatus includes or is operatively coupled to a control unit (7), wherein said control unit is adapted to carry out a diagnostic method (100) to monitor the operation of said switching apparatus during a switching manoeuvre, **characterized in that** said diagnostic method (100) comprises the following steps:

      - acquiring (101) detection signals (DS1, DS2) indicative of one or more electrical quantities (V, I) related to the operation of said switching apparatus, during a switching manoeuvre of said switching apparatus;
      - based on said detection signals, calculating (102), for each electrical quantity, a diagnostic waveform ($C_A$, $C_B$, $C_C$, $C_D$) indicative of an actual behaviour of said electrical quantity (V, I), during a switching manoeuvre of said switching apparatus;
      - selecting (103) a timing parameter ($\Delta tc$, $\Delta to$) to be calculated in relation to a switching manoeuvre of said switching apparatus;
      - selecting (104) a diagnostic waveform ($C_A$, $C_B$, $C_C$, $C_D$) and an observation time window ($T_A$, $T_B$, $T_C$, $T_D$) to calculate the selected timing parameter ($\Delta t_C$, $\Delta t_O$);
      - determining (105) a perturbation instant (tc, to) in the selected diagnostic waveform ($C_A$, $C_B$, $C_C$, $C_D$) during the selected observation time window ($T_A$, $T_B$, $T_C$, $T_D$);
      - calculating (106) the selected timing parameter ($\Delta tc$, $\Delta to$) based on the de-

   termined perturbation instant (tc, to).

2. Switching apparatus, according to claim 1, **characterised in that** the step (105) of determining said perturbation instant (tc) comprises:

   - calculating a first checking value ($ck_A$, $ck_B$) indicative of the derivative over time of the selected diagnostic waveform ($C_A$, $C_B$) during the selected observation time window ($T_A$, $T_B$);
   - comparing said first checking value ($ck_A$, $ck_B$) within a predefined first threshold value ($TH_A$, $TH_B$);
   - determining said perturbation instant (tc) as an instant, at which said first checking value ($ck_A$, $ck_B$) exceeds said first threshold value ($TH_A$, $TH_B$) during the selected observation time window ($T_A$, $T_B$).

3. Switching apparatus, according to one of the previous claims, **characterised in that** said perturbation instant (tc, to) is identified by:

   - calculating a second checking value ($ckc$, $ck_D$) indicative of a difference between the selected diagnostic waveform ($Cc$, $C_D$) and a reference waveform ($R_C$, $R_D$) indicative of an ideal profile of said electrical quantity (V, I) during the selected observation time window (Tc, $T_D$);
   - comparing said second checking value ($ck_C$, $ck_D$) with a predefined second threshold value ($TH_C$, $TH_D$);
   - determining said perturbation instant (tc, to) as an instant, at which said second checking value ($ck_C$, $ck_D$) exceeds said second threshold value ($TH_C$, $TH_D$) during the selected observation time window ($T_C$, $T_D$).

4. Switching apparatus, according to one of the previous claims, **characterised in that** said one or more electrical quantities include at least one between:

   - a voltage (V) feeding said electromagnetic actuator (4); and
   - an excitation current (I) feeding said electromagnetic actuator (4).

5. Switching apparatus, according to one of the previous claims, **characterised in that** said actuation assembly (3) includes one or more opening springs (5) operatively coupled to said movable contacts (11), wherein said electromagnetic actuator (4) is adapted to provide actuation forces directed in such a way to move said movable contacts (11) from said uncoupled position (A) to said coupled position (B), during a closing manoeuvre of said switching apparatus, wherein said opening springs (5) are adapted to provide actuation forces directed in such a way to move said movable contacts (11) from said coupled position (B) to said uncoupled position (A), during an opening manoeuvre of said switching apparatus.

6. Switching apparatus, according to one of the claims from 1 to 4, **characterised in that** said electromagnetic actuator (4) is adapted to provide actuation forces directed in such a way to move said movable contacts (11) from said uncoupled position (A) to said coupled position (B), during a closing manoeuvre of said switching apparatus, and to move said movable contacts (11) from said coupled position (B) to said uncoupled position (A), during an opening manoeuvre of said switching apparatus.

7. Switching apparatus, according to one of the previous claims, **characterised in that** it comprises a driving unit (6) electrically connected to said electromagnetic actuator (4) and adapted to feed said electromagnetic actuator with an excitation current ($I_L$, $I_H$) to operate said electromagnetic actuator.

8. Switching apparatus according to one of the previous claims, **characterised in that** it is a medium voltage switching apparatus.

9. A diagnostic method (100) to monitor the operation of a switching apparatus (1) during a switching manoeuvre, wherein said switching apparatus comprises:

   - one or more switch poles;
   - for each switch pole, one or more fixed contacts (10) and one or more movable contacts (11), wherein said movable contacts (11) are reversibly movable between an uncoupled position (A), at which said movable contacts are decoupled from said fixed contacts (10), and a coupled position (B), at which said movable contacts are coupled with said fixed contacts;
   - an actuation assembly (3) operatively coupled to said movable contacts (11), wherein said actuation assembly includes an electromagnetic actuator (4);

   **characterized in that** said diagnostic method (100) comprises the following steps:

   - acquiring (101) detection signals (DS1, DS2) indicative of one or more electrical quantities (V, I) related to the operation of said switching apparatus, during a switching manoeuvre of said switching apparatus;
   - based on said detection signals, calculating (102), for each electrical quantity, a diagnostic waveform ($C_A$, $C_B$, $C_C$, $C_D$) indicative of an actual behaviour of said electrical quantity (V, I), during a switching manoeuvre of said switching apparatus;
   - selecting (103) a timing parameter ($\Delta tc$, $\Delta to$) to be calculated in relation to a switching manoeuvre of said switching apparatus;
   - selecting (104) a diagnostic waveform ($C_A$, $C_B$, $C_C$, $C_D$) and an observation time window ($T_A$, $T_B$, $T_C$, $T_D$) to calculate the selected timing parameter ($\Delta t_C$, $\Delta t_O$);
   - determining (105) a perturbation instant (tc, to) in the selected diagnostic waveform ($C_A$, $C_B$, Cc, $C_D$) during the selected observation time window ($T_A$, $T_B$, $T_C$, $T_D$);
   - calculating (106) the selected timing parameter ($\Delta tc$, $\Delta to$) based on the determined perturbation instant (tc, to).

10. Diagnostic method, according to claim 9, **characterised in that** the step (105) of determining said perturbation instant (tc) comprises:

    - calculating a first checking value ($ck_A$, $ck_B$) indicative of the derivative over time of the selected diagnostic waveform ($C_A$, $C_B$) during the selected observation time window ($T_A$, $T_B$);
    - comparing said first checking value ($ck_A$, $ck_B$) within a predefined first threshold value ($TH_A$, $TH_B$);
    - determining said perturbation instant (tc) as an instant, at which said first checking value ($ck_A$, $ck_B$) exceeds said first threshold value ($TH_A$, $TH_B$) during the selected observation time window ($T_A$, $T_B$).

11. Diagnostic method, according to one of the claims from 9 to 10, **characterised in that** said perturbation instant (tc, to) is identified by:

    - calculating a second checking value (ckc, $ck_D$) indicative of a difference between the selected diagnostic waveform ($C_C$, $C_D$) and a reference waveform ($R_C$, $R_D$) indicative of an ideal profile of said electrical quantity (V, I) during the selected observation time window (Tc, $T_D$);
    - comparing said second checking value ($ck_C$, $ck_D$) with a predefined second threshold value ($TH_C$, $TH_D$);
    - determining said perturbation instant (tc, to) as an instant, at which said second checking value ($ck_C$, $ck_D$) exceeds said second threshold value ($TH_C$, $TH_D$) during the selected observation time window ($T_C$, $T_D$).

12. Diagnostic method, according to one of the claims from 9 to 11, **characterised in that** said one or more electrical quantities include at least one between:

    - a voltage (V) feeding said electromagnetic actuator (4); and

- an excitation current (I) feeding said electro-magnetic actuator (4).

EP 4 648 079 A1

open state
uncoupled position A

**FIG. 1**

FIG. 2

**FIG. 3**

EP 4 648 079 A1

**FIG. 3A**

**FIG. 3B**

EP 4 648 079 A1

**FIG. 4**

**FIG. 4A**

EP 4 648 079 A1

**FIG. 4B**

FIG. 5

FIG. 6

FIG. 7

EP 4 648 079 A1

**FIG. 8**

FIG. 9

EP 4 648 079 A1

FIG. 10

EP 4 648 079 A1

Europäisches
Patentamt
European
Patent Office
Office européen
des brevets

## PARTIAL EUROPEAN SEARCH REPORT

under Rule 62a and/or 63 of the European Patent Convention.
This report shall be considered, for the purposes of
subsequent proceedings, as the European search report

**Application Number**

EP 24 17 5067

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/020547 A1 (DELBAERE STÉPHANE [FR] ET AL) 20 January 2022 (2022-01-20) * claim 1; figure 3 * ----- | 1,9 | INV. H01H47/00 |
| X | US 9 733 292 B2 (SCHNEIDER ELECTRIC IND SAS [FR]) 15 August 2017 (2017-08-15) * claim 1; figures 3,4 * ----- | 1,9 | |
| X | US 2021/391132 A1 (CARLSON ANDREW E [US] ET AL) 16 December 2021 (2021-12-16) * claim 1; figures 7,8 * ----- | 1,9 | |
| X | US 2017/250042 A1 (BIANCO ANDREA [IT] ET AL) 31 August 2017 (2017-08-31) * claim 1; figure 5 * ----- | 1,9 | |
| X | US 11 959 966 B2 (SCHNEIDER ELECTRIC IND SAS [FR]) 16 April 2024 (2024-04-16) * claim 1; figure 7 * ----- | 1,9 | |
| X | US 7 739 058 B2 (MITSUBISHI ELECTRIC CORP [JP]) 15 June 2010 (2010-06-15) * claim 1; figures 2,3 * ----- | 1,9 | **TECHNICAL FIELDS SEARCHED (IPC)** H01H G01R H01F |

## INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 19 November 2024 | Simonini, Stefano |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04E07)

Europäisches
Patentamt

European
Patent Office

Office européen
des brevets

**INCOMPLETE SEARCH
SHEET C**

Application Number

EP 24 17 5067

Claim(s) searched incompletely:
        1-12

Reason for the limitation of the search:

The claims as a whole are unclear as they contain undefined parameters -
Art.84 EPC.
The electrical quantities detected in claims 1 and 9 are undefined.
It is not indicated what a diagnostic waveform is and how it is
calculated.
It is not indicated what a timing parameter is, how it is selected, and
how it is calculated.
Independent claims 1 and 9 are moreover directed to diagnosing the
operation of a circuit breaker, but they do not contain the essential
step of the actual diagnosis. Said claims end with the determination of a
(undefined) timing parameter. How this parameter is used to diagnose the
device is not in the claims.
In the letter of 15-11-2024 the applicant relies extensively on the
description and on the general knowledge of the skilled person to
interpret the claims. However, the claims must be clear on their own, and
the search division sees no reason to read features of the description
into the claims.

Finally and most crucially, neither the claims nor the description
describe how said unclear parameters are used to diagnose the device.
As the claims are directed to a device and a method of diagnosing a
switching device, the fact that the application as a whole fails to
indicate what and how is being diagnosed makes it impossible for the
skilled person to carry out the alleged invention. This is an objection
under Art.83 EPC and there appears to be no way of overcoming it.

## ANNEX TO THE EUROPEAN SEARCH REPORT
## ON EUROPEAN PATENT APPLICATION NO.

EP 24 17 5067

This annex lists the patent family members relating to the patent documents cited in the above-mentioned European search report.
The members are as contained in the European Patent Office EDP file on
The European Patent Office is in no way liable for these particulars which are merely given for the purpose of information.

19-11-2024

| Patent document cited in search report | | | Publication date | Patent family member(s) | | | Publication date |
|---|---|---|---|---|---|---|---|
| US 2022020547 | A1 | | 20-01-2022 | CN | 113960460 | A | 21-01-2022 |
| | | | | EP | 3944278 | A1 | 26-01-2022 |
| | | | | ES | 2986495 | T3 | 11-11-2024 |
| | | | | FR | 3112649 | A1 | 21-01-2022 |
| | | | | US | 2022020547 | A1 | 20-01-2022 |
| US 9733292 | B2 | | 15-08-2017 | CA | 2792825 | A1 | 21-04-2013 |
| | | | | CN | 103065869 | A | 24-04-2013 |
| | | | | EP | 2584575 | A1 | 24-04-2013 |
| | | | | ES | 2618515 | T3 | 21-06-2017 |
| | | | | FR | 2981787 | A1 | 26-04-2013 |
| | | | | JP | 6026217 | B2 | 16-11-2016 |
| | | | | JP | 2013089603 | A | 13-05-2013 |
| | | | | KR | 20130044187 | A | 02-05-2013 |
| | | | | TW | 201322291 | A | 01-06-2013 |
| | | | | US | 2013103334 | A1 | 25-04-2013 |
| US 2021391132 | A1 | | 16-12-2021 | NONE | | | |
| US 2017250042 | A1 | | 31-08-2017 | AU | 2015317193 | A1 | 16-03-2017 |
| | | | | CN | 107112166 | A | 29-08-2017 |
| | | | | EP | 2998977 | A1 | 23-03-2016 |
| | | | | US | 2017250042 | A1 | 31-08-2017 |
| | | | | WO | 2016041691 | A1 | 24-03-2016 |
| US 11959966 | B2 | | 16-04-2024 | CN | 114935717 | A | 23-08-2022 |
| | | | | EP | 4040173 | A1 | 10-08-2022 |
| | | | | FR | 3119461 | A1 | 05-08-2022 |
| | | | | US | 2022252667 | A1 | 11-08-2022 |
| US 7739058 | B2 | | 15-06-2010 | CN | 101375359 | A | 25-02-2009 |
| | | | | EP | 1998351 | A1 | 03-12-2008 |
| | | | | HK | 1127528 | A1 | 25-09-2009 |
| | | | | JP | 4535193 | B2 | 01-09-2010 |
| | | | | JP | WO2007108063 | A1 | 30-07-2009 |
| | | | | TW | I321333 | B | 01-03-2010 |
| | | | | US | 2009138212 | A1 | 28-05-2009 |
| | | | | WO | 2007108063 | A1 | 27-09-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3460822 A1